# EUROPEAN PATENT SPECIFICATION

(11) **EP 0 472 592 B1**
(45) Date of publication and mention of the grant of the patent: **27.09.1995**
(21) Application number: 90907692.9
(22) Date of filing: 14.05.1990
(51) Int. Cl.: H01L 29/06, H01L 29/74, H01L 27/02

(54) **LOW TRIGGER VOLTAGE SCR PROTECTION DEVICE AND STRUCTURE**
SCR-SCHUTZANORDNUNG MIT NIEDRIGER ZÜNDSPANNUNG UND STRUKTUR
STRUCTURE ET DISPOSITIF DE PROTECTION MUNI D'UN REDRESSEUR AU SILICIUM COMMANDE A BASSE TENSION DE DECLENCHEMENT

(30) Priority: 17.05.1989 GB 8911360; 04.05.1990 US 516498
(43) Date of publication of application: 04.03.1992
(73) Proprietor: DAVID SARNOFF RESEARCH CENTER, INC., Princeton, NJ 08543-5300 (US); SHARP CORPORATION, Tenri, Nara 632 (JP)
(72) Inventor: AVERY, Leslie, Ronald, Hunterdon, NJ 08822 (US)
(74) Representative: Harris, Ian Richard
(86) International application number: US9002610
(87) International publication number: WO9014691

(56) References cited:
- US-A- 4 100 561
- US-A- 4 167 018
- US-A- 4 176 372
- US-A- 4 213 140
- US-A- 4 224 634
- US-A- 4 327 368

## Description

The present invention relates generally to protection devices for integrated circuits.

Many attempts have been made in the prior art to protect semiconductor devices, including bipolar transistors, field effect devices, and integrated circuits against damage due to voltage and current transients. Such protection devices have commonly taken the form of diode or transistor circuits that have been incorporated on the integrated circuit chip for internal transient protection. The design engineer is nevertheless faced with the problem of having to use valuable chip space for forming protection devices. Particularly on devices containing a large number of pins, it has been found that the protection devices occupy a significant amount of space and, therefore, the chip can become undesirably large.

Protection circuits advantageously utilizing silicon controlled rectifier (SCR) arrangements are known, for example, from Avery, U.S. Patent No. 4,484,561; Kokado et al., U.S. Patent No. 4,631,657; and Avery, U.S. Patent No. 4,633,283.

In typical SCR arrangements utilized in the protection of integrated circuits, the trigger or firing voltage under quasistatic conditions is on the order of 25 volts to 40 volts. However, in practice, pulse conditions typically prevail and the actual trigger voltage is generally higher because of the time taken to establish the plasma. When such an SCR arrangement is utilized as part of an ESD protection circuit on a VLSI chip, for example, damage to other parts of the chip could occur before the "snap-back" SCR conduction regime has been established, ie before the SCR has achieved its "shorted" state. It is therefore desirable to achieve a lower trigger voltage for the SCR.

In accordance with the present invention, there is provided a protection device comprising: a semiconductor substrate of a first conductivity type having a surface; a first region of second conductivity type in said substrate at said surface and having a boundary with said substrate; a second region of said second conductivity type within said first region and at said substrate surface; a third region of said first conductivity type within said first region at said substrate surface and adjacent said second region; a fourth region, which has a higher conductivity than the first region, in said first region at said substrate surface and extending across the boundary with the substrate into said substrate; a fifth region of said second conductivity type in said substrate at said surface and spaced apart from said first region; a first electrode in electrical contact with both said second and third regions; and a second electrode in electrical contact with both said fifth and sixth regions; said substrate, first region and fifth region forming a first bipolar transistor of one conductivity type, and said substrate, first region and third region forming a second bipolar transistor of the opposite conductivity type which is connected to the first bipolar transistor to form an SCR.

Other preferred features of the invention are defined in the appended dependent claims.

Specific embodiments of the present invention will now be described by way of example with reference to the accompanying drawings, in which:
Fig. 1 shows a cross-section, not to scale, of an embodiment of the invention;
Fig. 2 shows a schematic of an equivalent circuit corresponding to the embodiment of Fig. 1;
Figs. 3 and 4 show cross-sections, not to scale, of other embodiments of the invention; and
Fig. 5 shows a protection circuit connected to an integrated circuit.

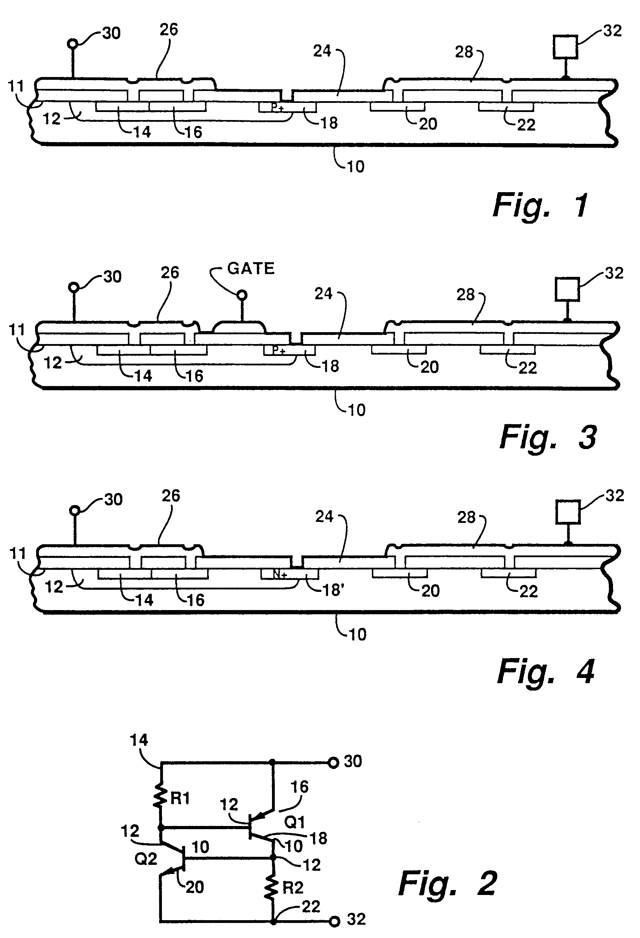

In Fig. 1, an embodiment of the present invention is shown which is compatible with typical integrated circuit processing techniques. In Fig. 1, a substrate 10 is composed of a P- type conductivity semiconductor material such as silicon having a surface 11. It is typically relatively lightly doped, 10¹³/cc, and has a relatively low degree of conductivity. A region 12 of N- type conductivity, also relatively lightly doped and having relatively low conductivity is formed in substrate 10 at the surface 11. This region is usually referred to as a "well", in this case, an N- well.

N- well 12 has formed within it near the surface 11 a relatively heavily doped (typically 10¹⁸/cc) N+ type conductivity region 14 and a relatively heavily doped P+ type conductivity region 16, both having relatively high conductivity. Regions 14 and 16 are formed entirely within the boundary of N- well 12 and preferably abut one another.

A further region 18 is formed in N- well 12 in part, and in substrate 10 in part, thus extending through the boundary of N- well 12 into substrate 10. The further region 18 may be either N+ or P+ conductivity type.

Substrate 10 has also formed within it at the surface 11 a relatively heavily doped N+ type conductivity region 20 and a relatively heavily doped P+ type conductivity region 22. Region 22 preferably abuts region 20. Regions 20 and 22 have relatively high conductivity and are formed entirely outside the boundary of N- well 12.

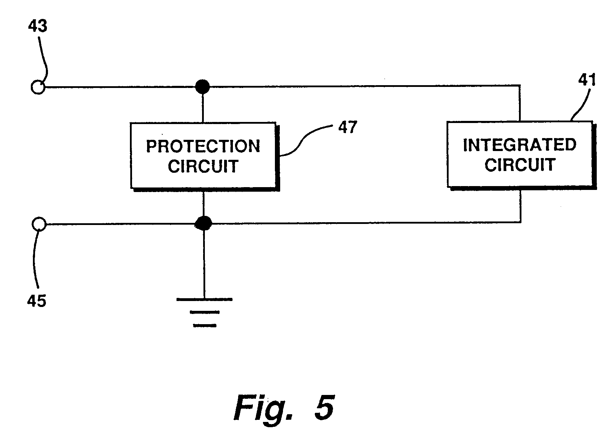

The surface 11 of substrate 10 and of the regions formed within it are covered by an insulating layer 24 which may be silicon dioxide, typically about 0.5 micrometers thick. Openings are provided through layer 24 for contacts. A first conductive layer 26, which may be aluminium, molybdenum, silicide or polysilicon, makes contact with each of regions 14 and 16. A second conductive layer 28 makes contact with each of regions 20 and 22. By way of example, conductive layer 26 is here connected to a terminal 30 and conductive layer 28 is connected to terminal 32. For example, Fig. 5 shows one possible arrangement in which an integrated circuit 41 is connected between a first terminal 43 and a second terminal 45. In the present example, terminal 43 is a supply terminal for a voltage, VDD, of first polarity and terminal 45 is shown as a supply terminal for a reference voltage VSS, typically ground potential. However, terminal 43 can be an input or output signal terminal rather than a supply terminal. In Fig. 5, a protection circuit 47 is connected between terminals 43 and 45, that is, in parallel with integrated circuit 41. Protection circuit 47 thereby protects integrated circuit 41 by turning on in response to transient voltages to conduct transient energy to a source of reference potential, ground in this example.

In operation, the arrangement of Fig. 1 functions as a protective device with "SCR-type" behaviour to provide protection when a certain trigger voltage is reached or exceeded. When this has occurred, a low resistance path is provided between terminals 30 and 32 for limiting any voltage excursion. It will be helpful to an understanding of the operation of the protective device of Fig. 1 to consider the equivalent circuit of Fig. 2. The explanation will be simplified by first describing the operation without the presence of region 18.

Referring to Figs. 1 and 2, N- well 12 forms the base electrode of PNP transistor Q1 and P+ region 16 forms its emitter, connected to terminal 30. P- substrate 10 forms the collector of transistor Q1. Resistor R1, connected between the emitter and base electrodes of transistor Q1, is formed substantially by the part of N- well 12 between region 14 and the edge of N- well 12 closest to N+ region 20.

The emitter of NPN transistor Q2 is formed by N+ region 20. Its base is formed by P- substrate 10 and its collector is formed by N-well 12. The emitter-base shunt resistor R2 is formed substantially by the region between the edge of N- well 12 and P+ region 22. The arrangement of Q1 and Q2 forms an SCR having a threshold level above which it will be triggered into conduction, whereupon a "snap-back" voltage-current characteristic will be exhibited. The effective values of resistances R1 and R2 will primarily affect the value of the "holding current" below which the SCR will "unlatch" and substantially cease conduction.

The trigger voltage at which the conduction regime will be initiated is determined by breakdown voltages between component regions of the SCR. In the absence of region 18, triggering of the SCR will occur when the breakdown voltage between N- well 12 and P- substrate 10 is exceeded. In Fig. 2, this breakdown occurs across the junction between the base and collector electrodes of PNP transistor Q1 of NPN transistor Q2. In a typical CMOS process the breakdown voltage will be between about 25 volts and 40 volts but, as earlier stated, the time taken to establish a plasma providing full conduction will result in higher effective "snap-back" trigger voltages for the short pulse durations encountered in typical electrostatic discharge transients.

In Figs. 1 and 2, because of the higher doping level of region 18, the breakdown voltage between P+ region 18 and N- well 12 will be less than the breakdown voltage between P- substrate 10 and N- well 12. In effect, the P+ region 18 rather than substrate 10 forms the collector electrode of PNP transistor Q1. Accordingly, the lower breakdown voltage will control, and thus a lower "snap-back" trigger voltage for the SCR is achieved. The actual value of the trigger voltage can be controlled to a certain extent by selecting different spacings between P+ region 16 and P+ region 18.

In Fig. 4, the further region 18′ is of relatively highly doped N type conductivity material (N+). The breakdown voltage between N+ region 18′ and substrate 10 is lower than the breakdown voltage between N- well 12 and substrate 10. Consequently, the trigger voltage for the SCR is lowered in this manner.

Referring now to Fig. 3, a gate electrode overlies the portion of N- well 12 between regions 16 and 18. When the gate electrode is appropriately biased, a conduction channel is established between regions 16 and 18. This is equivalent to conduction in the emitter collector path of PNP transistor Q1 and will lead to a lower trigger voltage for the SCR. By maintaining the gate at a reference potential, appropriate biasing can result from a positive transient potential on conductive layer 26.

The devices of the invention can be fabricated utilizing standard photolithographic and etching steps for definition and ion implantation for forming the doped regions. Typically, a silicon substrate is used with, for example, boron as a P type dopant and phosphorus as an N type dopant, other suitable materials may be used.

Modifications of the various embodiments of the invention may occur to one skilled in the art. For example, while the exemplary embodiment has been described in terms of particular conductivity types, converse conductivity types may be used so long as the relative conductivity types remain the same. Also, the region 22 may be arranged so that it abuts the region 20.

## Claims

1. A protection device comprising:
a semiconductor substrate (10) of a first conductivity type having a surface (11);
a first region (12) of second conductivity type in said substrate at said surface and having a boundary with said substrate;
a second region (14) of said second conductivity type within said first region and at said substrate surface;
a third region (16) of said first conductivity type within said first region at said substrate surface and adjacent said second region;
a fourth region (18), which has a higher conductivity than the first region, in said first region at said substrate surface and extending across the boundary with the substrate into said substrate;
a fifth region (20) of said second conductivity type in said substrate at said surface and spaced apart from said first region;
a sixth region (22) of said first conductivity type in said substrate at said surface and spaced apart from said first region;
a first electrode (26) in electrical contact with both said second and third regions; and
a second electrode (28) in electrical contact with both said fifth and sixth regions;
said substrate (10), first region (12) and fifth region (20) forming a first bipolar transistor (Q2) of one conductivity type, and said substrate (10), first region (12) and third region (16) forming a second bipolar transistor (Q1) of the opposite conductivity type which is connected to the first bipolar transistor (Q2) to form an SCR.

2. The device of claim 1 wherein said sixth region (22) abuts the fifth region (20).

3. The device of claim 1 wherein said third and fourth regions are spaced apart along said substrate surface to form source and drain regions of a field effect device and wherein a control gate means (GATE) overlies and is insulated from the substrate surface between said third and fourth regions for controlling the degree of conduction between said third and fourth regions.

4. The device of claim 1 or 3, wherein said fourth region (18) is of said first conductivity type.

5. The device of claim 1 or 3, wherein said fourth region (18) is of said second conductivity type.

6. A structure comprising:
an integrated circuit (41) having a first terminal (45) connected to a source of reference potential and a second terminal (43); and
an SCR protection device (47) as claimed in any preceding claim;
said first terminal being in electrical contact with said first electrode, and said second terminal being in electrical contact with said second electrode.

7. The structure of claim 6, wherein said second terminal is an input signal terminal of said integrated circuit.

8. The structure of claim 6, wherein said second terminal is an output signal terminal of said integrated circuit.

9. The structure of claim 6, wherein said second terminal is a voltage supply terminal of said integrated circuit.

## Patentansprüche

1. Schutzvorrichtung mit:
einem Halbleitersubstrat (10) vom Typ einer ersten Leitfähigkeit, mit einer Oberfläche (11);
einem ersten Bereich (12) vom Typ einer zweiten Leitfähigkeit in dem Substrat und an der Oberfläche und mit einer Grenze mit dem Substrat;
einem zweiten Bereich (14) vom Typ der zweiten Leitfähigkeit innerhalb des ersten Bereiches und an der Substratoberfläche;
einem dritten Bereich (16) vom Typ der ersten Leitfähigkeit innerhalb des ersten Bereiches an der Substratoberfläche und neben dem zweiten Bereich;
einem vierten Bereich (18), der eine höhere Leitfähigkeit hat als der erste Bereich, in dem ersten Bereich an der Substratoberfläche, wobei sich dieser vierte Bereich über die Grenze mit dem Substrat in das Substrat hinein erstreckt;
einem fünften Bereich (20) vom Typ der zweiten Leitfähigkeit in dem Substrat an der Oberfläche und im Abstand von dem ersten Bereich;
einem sechsten Bereich (22) vom Typ der ersten Leitfähigkeit in dem Substrat an der Oberfläche und im Abstand von dem ersten Bereich;
einer ersten Elektrode (26) in elektrischem Kontakt sowohl mit dem zweiten als auch mit dem dritten Bereich; und
einer zweiten Elektrode (28) in elektrischem Kontakt sowohl mit dem fünften als auch dem sechsten Bereich;
wobei das Substrat (10), der erste Bereich (12) und der fünfte Bereich (20) einen ersten bipolaren Transistor (Q2) vom Typ einer Leitfähigkeit bilden und das Substrat (10), der erste Bereich (12) und der dritte Bereich (16) einen zweiten bipolaren Transistor (Q1) vom Typ mit entgegengesetzter Leitfähigkeit bilden, der mit dem ersten bipolaren Transistor (Q2) zur Bildung eines SCR verbunden ist.

2. Vorrichtung nach Anspruch 1, wobei der sechste Bereich (22) an den fünften Bereich (20) anstößt.

3. Vorrichtung nach Anspruch 1, wobei der dritte und der vierte Bereich entlang der Substratoberfläche im Abstand angeordnet sind, um Quellen- und Senkenbereiche einer Feldeffektvorrichtung zu bilden, und wobei ein Steuergattermittel über der Substratoberfläche zwischen dem dritten und dem vierten Bereich liegt und von dieser Oberfläche isoliert ist, um den Fortleitungsgrad zwischen dem dritten und vierten Bereich zu steuern.

4. Vorrichtung nach Anspruch 1 oder 3, wobei der vierte Bereich (18) vom Typ mit der ersten Leitfähigkeit ist.

5. Vorrichtung nach Anspruch 1 oder 3, wobei der vierte Bereich (18) vom Typ der zweiten Leitfähigkeit ist.

6. Aufbau mit:
einer integrierten Schaltung (41) mit einem ersten Anschluß (45), der mit einer Bezugspotentialquelle verbunden ist, und einem zweiten Anschluß (43); und mit einer SCR Schutzanordnung (47), entsprechend einem vorherigen Anspruch;
wobei der erste Anschluß in elektrischem Kontakt mit der ersten Elektrode steht und der zweite Anschluß in elektrischem Kontakt mit der zweiten Elektrode steht.

7. Aufbau nach Anspruch 6, wobei der zweite Anschluß ein Eingangssignalanschluß der integrierten Schaltung ist.

8. Aufbau nach Anspruch 6, wobei der zweite Anschluß ein Ausgangssignalanschluß der integrierten Schaltung ist.

9. Aufbau nach Anspruch 6, wobei der zweite Anschluß ein Spannungszufuhranschluß der integrierten Schaltung ist.

## Revendications

1. Dispositif de protection comprenant :
un substrat semi-conducteur (10) d'un premier type de conductivité comportant une face (11) ;
une première région (12) du second type de conductivité dans ledit substrat au droit de ladite face et ayant une frontière avec ledit substrat ;
une deuxième région (14) dudit second type de conductivité à l'intérieur de ladite première région et au droit de ladite face de substrat ;
une troisième région (16) dudit premier type de conductivité à l'intérieur de ladite première région au droit de ladite face de substrat et adjacente à ladite deuxième région ;
une quatrième région (18), qui a une conductivité plus élevée que la première région, dans ladite première région au droit de ladite face de substrat et s'étendant dans ledit substrat au-delà de la frontière avec le substrat ;
une cinquième région (20) dudit second type de conductivité dans ledit substrat au droit de ladite face et espacée de ladite première région ;
une sixième région (22) dudit premier type de conductivité dans ledit substrat au droit de ladite face et espacée de ladite première région ;
une première électrode (26) en contact électrique avec à la fois lesdites deuxième et troisième régions ; et
une seconde électrode (28) en contact électrique avec à la fois lesdites cinquième et sixième régions ;
ledit substrat (10), ladite première région (12) et ladite cinquième région (20) formant un premier transistor bipolaire (Q2) d'un type de conductivité, et ledit substrat (10), ladite première région (12) et ladite troisième région (16) formant un second transistor bipolaire (Q1) du type de conductivité opposé, qui est connecté au premier transistor bipolaire (Q2) pour former un SCR (redresseur commandé au silicium).

2. Dispositif selon la revendication 1, dans lequel ladite sixième région (22) est bout à bout avec la cinquième région (20).

3. Dispositif selon la revendication 1, dans lequel lesdites troisième et quatrième régions sont espacées sur la face dudit substrat pour former des régions de source et de drain d'un dispositif à effet de champ, et dans lequel un moyen formant grille de commande (GRILLE) recouvre la face de substrat, et en est isolé, entre lesdites troisième et quatrième régions pour commander le degré de conduction entre lesdites troisième et quatrième régions.

4. Dispositif selon la revendication 1 ou 3, dans lequel ladite quatrième région (18) est dudit premier type de conductivité.

5. Dispositif selon la revendication 1 ou 3, dans lequel ladite quatrième région (18) est dudit second type de conductivité.

6. Structure comprenant :
un circuit intégré (41) ayant une première borne (45) connectée à une source de potentiel de référence et une seconde borne (43) ; et
un dispositif de protection à SCR (47) selon l'une quelconque des revendications précédentes ;
ladite première borne étant en contact électrique avec ladite première électrode, et ladite seconde borne étant en contact électrique avec ladite seconde électrode.

7. Structure selon la revendication 6, dans laquelle ladite seconde borne est une borne de signal d'entrée dudit circuit intégré.

8. Structure selon la revendication 6, dans laquelle ladite seconde borne est une borne de signal de sortie dudit circuit intégré.

9. Structure selon la revendication 6, dans laquelle ladite seconde borne est une borne d'alimentation en tension dudit circuit intégré.
